**Europäisches Patentamt**

**European Patent Office**

**Office européen des brevets**

(19)

(11) Publication number: **0 108 325**
**B1**

(12) EUROPEAN PATENT SPECIFICATION

(45) Date of publication of patent specification: **19.08.87**

(21) Application number: **83110608.3**

(22) Date of filing: **24.10.83**

(51) Int. Cl.⁴: **G 01 K 1/02, G 01 K 7/24,**
**G 01 R 15/08, G 01 D 3/02**

(54) **Device to measure temperature.**

(30) Priority: **29.10.82 IT 8347182**

(43) Date of publication of application:
**16.05.84 Bulletin 84/20**

(45) Publication of the grant of the patent:
**19.08.87 Bulletin 87/34**

(84) Designated Contracting States:
**AT BE CH DE FR GB IT LI LU NL SE**

(56) References cited:
**DE-A-2 739 024**
**US-A-4 161 880**

**ELECTRONIC ENGINEERING, vol. 51, no. 631,**
**November 1979, page 21, London, GB. T.**
**HERLESTAM: "Automatic range extension-**
**sensitivity unchanged"**

(73) Proprietor: **ZELTRON ISTITUTO ZANUSSI PER**
**L'ELETTRONICA S.P.A.**
**Via Principe di Udine, 66**
**I-33030 Campoformido Udine (IT)**

(72) Inventor: **Rotoloni, Pietro**
**via Monte Zebio 19**
**I-36031 Dueville (Vicenza) (IT)**

(74) Representative: **Patentanwälte Grünecker, Dr.**
**Kinkeldey, Dr. Stockmair, Dr. Schumann, Jakob,**
**Dr. Bezold, Meister, Hilgers, Dr. Meyer-Plath**
**Maximilianstrasse 58**
**D-8000 München 22 (DE)**

Courier Press, Leamington Spa, England.

# Description

The present invention relates to a device for measuring temperature in accordance with the prior art portion of Claim 1.

US—A—4 161 880 discloses a device for measuring temperature comprising a thermistor generating an output voltage depending on the environment temperature. The thermistor is fed by a current source. The voltage drop over said thermistor is converted into a digital signal which in turn is fed to a computerized system for generating a digital temperature value to be displayed on a display unit. When making use of commercially available low-cost analogue-to-digital converters, the possible temperature range is restricted due to a relatively narrow range of input values of the analogue-to-digital converter.

Although it might be possible to flatten the output curve of said thermistor by making use of a resistor network, these measures would not be sufficient to adapt the output voltage of said thermistor to the measurement range of the analogue-to-digital converter without losing the necessary sensitivity.

An automatic range extension circuit is described in "Electronic Engineering", volume 51, number 631, November 1979, page 21. The prior art automatic range extension circuit consists of a plurality of operational amplifier circuits. A resistor network generates a plurality of reference voltages equally distributed over the desired measurement range. These reference voltages are fed to the inverting input terminals of the operational amplifiers. The non-inverting input terminal of these operational amplifiers is supplied with an input voltage. The output signals of the operational amplifiers are fed to a common node wire transmission gate. The transmission characteristic of said prior art circuit has a sawtooth-like form.

In view of this state of art, the present invention is based on the technical task of creating a device for measuring temperature of the above mentioned kind covering a wide range of temperatures and making use of commercially available low-cost circuit elements.

This technical task is solved by a device for measuring temperature in accordance with the prior art portion of Claim 1 having the characterizing features thereof. In accordance with the present invention, the voltage/temperature-characteristic of the thermistor is displaced or shifted at least once for covering the whole measurement range. Preferably, the characteristic is shifted or displaced for a first time for enabling the minimum value or the maximum value to be set. Then it is shifted or displaced for a second time in the course of reading the whole temperature range.

In accordance with the present invention, the shifting of the curve from one position to another is effected by making use of a computerized system controlling at least one transistor.

Hence, the voltage/temperature characteristic is split into two curves for achieving a first transposed curve covering a temperature range from 10°C to 15°C up to 140°C to 150°C and another curve covering for example, from 110°C to 120°C up to 290°C to 300°C. In accordance with the present invention, the second resistor can be shunted by means of the transistor. The measurement takes place by selecting first of all one of the two curves and by thereinafter selecting the other curve which has not been chosen before in case the output voltage does not fall within the range belonging to the curve which has been chosen first.

Hereinafter, a preferred embodiment will be described in more detail with reference to the attached drawings, in which:—

Fig. 1 shows a device for measuring temperature in accordance with the present invention;

Fig. 2 shows two temperature/voltage characteristics of the embodiment as shown in Fig. 1; and

Fig. 3 shows a simplified diagram of the overall circuitry.

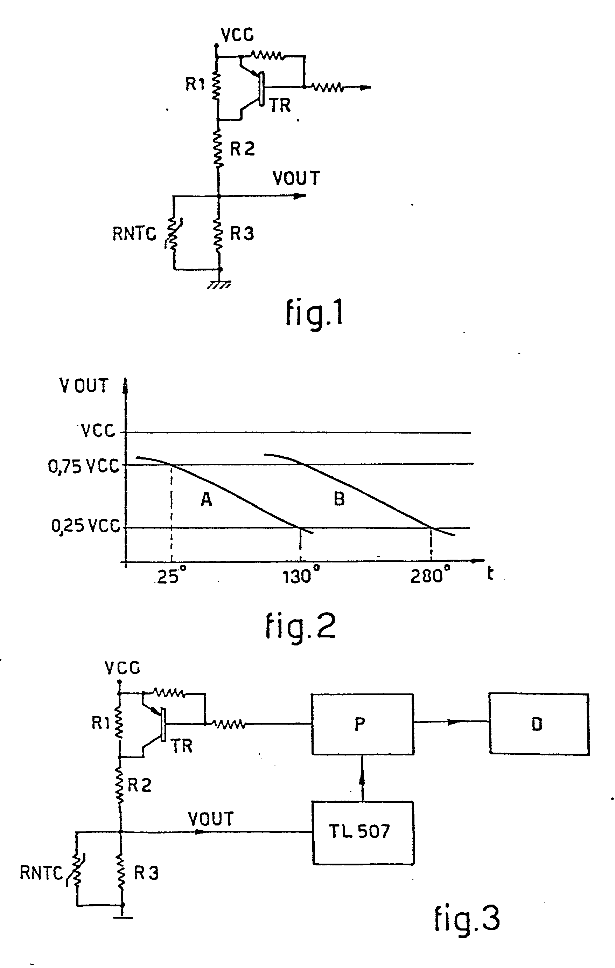

A thermistor RNTC is used as a temperature probe within the circuitry as shown in Fig. 1. The resistor R3 having a suitable resistence serves to modify the slope of the voltage/temperature-curve or voltage/temperature-characteristic of the thermistor according to specific requirements. The resistor R3 is connected in parallel with the thermistor RNTC.

Two resistors R1 and R2 are connected in series with respect to the thermistor RNTC.

The resistor R2 is always used as serial resistance. The other resistor R1 can be shunted when actuating a transistor TR connected in parallel to said resistor R1.

Reference numeral VCC designates the supply voltage. Reference numeral VOUT designates an analogue output voltage of the analogue-to-digital converter.

Fig. 2 shows the transmission characteristic of the circuitry in accordance with the Fig. 1 embodiment.

Let us assume that the temperature measurement is started at low temperatures, for example, between 25°C and 130°C when, for example, beginning with the heating of an oven. First of all, both resistors R1 and R2 are switched to be connected in series connection with respect to the thermistor RNTC. In this case, the first curve A is obtained.

As soon as the output voltage VOUT reaches the extreme value of the straight-line band or of the first curve corresponding to 0.25 VCC in the present embodiment, the transistor TR is switched over in its conductive state. In this state, the first resistor R1 is shunted, so that the thermistor RNTC is only in series connection with the second resistor R2.

Consequently, the voltage/temperature-characteristic is shifted to the curve B so that higher temperature values between 130°C and 280°C can be measured.

Fig. 3 shows an overall diagram of a simplified circuit structure adapted to be used together with the circuitry in accordance with Fig. 1.

The output voltage VOUT is converted by an analogue-to-digital converter into a digital signal. In the preferred embodiment, the analogue-to-digital converter is a TL507-module manufactured by Texas Instruments.

A microprocessor P connected to said analogue-to-digital converter interprets the digital output signal received from said analogue-to-digital converter and controls the on-or-off state of the transistor TR for selecting between the two temperature ranges in accordance with said digital output signal.

The temperature values are displayed on an appropriate display unit comprising a memory D, which display unit is controlled by said microprocessor P.

Many modifications of the above described preferred embodiment have been disclosed to a man skilled in the electronic field without departing from the scope of protection. For example, the analogue-to-digital converter of the type TL507 may be replaced by any other analogue-to-digital converter.

**Claims**

1. Device for measuring temperature comprising a thermistor (RNTC) generating an output voltage (VOUT) depending on its temperature, said thermistor (RNTC) being coupled to a computerized system (P) converting said output voltage (VOUT) to a temperature value to be displayed characterized in that

said thermistor (RNTC) is connected in series with at least two resistances (R1, R2) of which at least one (R1) is bridged by a transistor (TR), and

the state of said transistor is controlled by said computerized system (P) interpreting said output voltage (VOUT) of said thermistor (RNTC).

2. Device for measuring temperature as claimed in Claim 1 characterized in that said analogue output voltage (VOUT) is converted into a digital signal by an analogue-to-digital converter, and

said computerized system comprises a microprocessor (P) interpreting said digital signal for controlling the state of said transistor (TR).

3. Device for measuring temperature as claimed in Claims 1 or 2 characterized in that said temperature value is displayed on a display unit including a memory (D) controlled by said microprocessor (P).

**Patentansprüche**

1. Temperaturmeßvorrichtung mit einem Thermistor (RNTC), der eine Ausgansspannung (VOUT) in Abhängigkeit von seiner Temperatur erzeugt, wobei der Thermistor (RNTC) mit einem computerisierten System (P) verbunden ist, welches die Ausgangsspannung (VOUT) in einen anzuzeigenden Temperaturwert umwandelt, dadurch gekennzeichnet,

daß der Thermistor (RNTC) in Serie mit zumindest zwei Widerständen (R1, R2) verbunden ist, von denen zumindest einer (R1) mittels eines Transistors (TR) überbrückbar ist, und daß der Betriebszustand des Transistors von dem computerisierten System (P) gesteuert wird, welches die Ausgangsspannung (VOUT) des Thermistors (RNTC) auswertet.

2. Temperaturmeßvorrichtung nach Anspruch 1, dadurch gekennzeichnet, daß die analoge Ausgangsspannung (VOUT) mittels eines Analog-Digitalwandlers in ein Digitalsignal umgewandelt wird und daß das computerisierte System einen Mikroprozessor (P) umfaßt, welcher das Digitalsignal zur Steuerung des Betriebszustands des Transistors (TR) auswertet.

3. Temperaturmeßvorrichtung nach Anspruch 1 oder 2, dadurch gekennzeichnet, daß der Temperaturwert auf einer Anzeigeeinrichtung angezeigt wird, die einen durch den Mikroprozessor (P) gesteuerten Speicher (D) umfaßt.

**Revendications**

1. Dispositif pour mesurer la température, comportant un thermistor (RNTC) produisant une tension de sortie (VOUT) en fonction de sa température, ce thermistor (RNTC) étant couplé à un système de calcul (P) transformant cette tension de sortie (VOUT) en une valeur de température à afficher, caractérisé en ce que:

ce thermistor (RNTC) est raccordé en série avec au moins deux résistances (R1, R2) dont au moins l'une (R1) est ponté par un transistor (IR), et

l'état de ce transistor est commandé par ce système de calcul (P) interprétant la tension de sortie (VOUT) de ce thermistor (RNTC).

2. Dispositif pour mesurer la température selon revendication 1, caractérisé en ce que:

cette tension de sortie analogique (VOUT) est transformée en un signal numérique par un convertisseur analogique/numérique, et

ce système de calcul comporte un microprocesseur (P) interprétant le signal numérique pour commander l'état du transistor (TR).

3. Dispositif pour mesurer la température selon les revendications 1 ou 2, caractérisé en ce que cette valeur de température est affichée sur une unité de visualisation comportant une mémoire (D) commandée par le microprocesseur (P).

fig.1

fig.2

fig.3